# FASCICULE DE BREVET EUROPEEN

(11) **EP 3 478 870 B1**
(45) Date de publication et mention de la délivrance du brevet: **06.04.2022**
(21) Numéro de dépôt: 17745802.3
(22) Date de dépôt: 27.06.2017
(51) Int. Cl.: C23C 16/04, C23C 16/32, C04B 35/571, C04B 35/628, C04B 35/80

(54) **PROCÉDÉ D'INFILTRATION OU DE DÉPÔT CHIMIQUE EN PHASE VAPEUR**
VERFAHREN ZUR CHEMISCHEN DAMPFABSCHEIDUNG ODER INFILTRATION
METHOD FOR CHEMICAL VAPOUR DEPOSITION OR INFILTRATION

(30) Priorité: 29.06.2016 FR 1656092
(43) Date de publication de la demande: 08.05.2019
(73) Titulaire: Safran Ceramics, 33185 Le Haillan (FR)
(72) Inventeur: GOUJARD, Stéphane, 77550 Moissy-Cramayel Cedex (FR); DELCAMP, Adrien, 77550 Moissy-Cramayel Cedex (FR); DESCAMPS, Cédric, 77550 Moissy-Cramayel Cedex (FR)
(74) Mandataire: Cabinet Beau de Loménie
(86) Numéro de dépôt international: PCT/FR2017/051712
(87) Numéro de publication internationale: WO 2018/002510

(56) Documents cités:
- EP-A1- 2 933 353
- CA-A1- 2 937 144
- US-A- 5 733 655
- HENGGE E ET AL: "THE FORMATION OF SILICON CARBIDE FILMS FROM DISILANE DERIVATIVES", ADVANCED MATERIALS, WILEY - V C H VERLAG GMBH & CO. KGAA, DE, vol. 6, no. 7/08, 1 juillet 1994 (1994-07-01), pages 584-587, XP000457134, ISSN: 0935-9648, DOI: 10.1002/ADMA.19940060713

## Description

### Arrière-plan de l'invention

L'invention concerne un procédé d'infiltration ou de dépôt chimique en phase vapeur dans lequel du carbure de silicium (SiC) est formé dans la porosité d'un substrat poreux ou sur une surface d'un substrat.

La mise en œuvre de matériaux composites à matrice céramique de carbure de silicium est connue dans le domaine aéronautique et aérospatial. De tels matériaux composites présentent de bonnes propriétés mécaniques les rendant aptes à constituer des éléments de structures et conservent avantageusement ces propriétés à températures élevées.

Ces matériaux peuvent être fabriqués par densification par voie gazeuse d'une préforme fibreuse par une matrice de carbure de silicium (technique d'infiltration chimique en phase vapeur ou « Chemical Vapor Infiltration » dite « CVI »). Dans une telle technique, la préforme à densifier est placée dans un four de densification dans laquelle une phase gazeuse comprenant un précurseur de carbure de silicium est introduite. Un précurseur typiquement utilisé pour former une matrice de carbure de silicium stoechiométrique est le méthyltrichlorosilane (CH₃SiCl₃ ou MTS). Le choix du MTS est justifié par le fait que, dans la molécule même de MTS, le carbone et le silicium sont présents dans une proportion identique, tout comme dans le carbure de silicium stoechiométrique recherché. Un tel procédé de densification CVI est particulièrement fiable mais peut présenter une limitation en termes de rendement de dépôt obtenu, ce qui peut conduire à un allongement du cycle de traitement et donc à un coût de mise en œuvre relativement élevé. En effet, une partie du précurseur MTS peut être consommée pour faire un dépôt riche en silicium non valorisable à l'entrée du four. Le silicium ainsi consommé n'est plus disponible pour former la matrice de carbure de silicium à l'intérieur des préformes présentes dans la zone utile du four, limitant ainsi le rendement de dépôt.

Par ailleurs, dans le cas où les préformes à densifier sont épaisses, le procédé CVI qui vient d'être décrit peut ne pas conduire à un remplissage optimal de la porosité de ces préformes. On connait EP 2 933 353 qui divulgue un procédé de production de composites renforcés par des fibres.

Il existe donc un besoin pour disposer de procédés permettant de former du carbure de silicium stoechiométrique par voie gazeuse avec un rendement amélioré.

Il existe aussi un besoin pour disposer de procédés CVI permettant de former du carbure de silicium stoechiométrique à l'intérieur de substrats poreux avec un taux de remplissage de la porosité amélioré.

### Objet et résumé de l'invention

A cet effet, l'invention propose, selon un premier aspect, un procédé d'infiltration ou de dépôt chimique en phase vapeur comprenant au moins l'étape suivante :
- formation de carbure de silicium stoechiométrique dans la porosité d'un substrat poreux ou sur une surface d'un substrat, le substrat étant placé dans une enceinte réactionnelle, le carbure de silicium stoechiométrique étant formé à partir d'une phase gazeuse introduite dans l'enceinte réactionnelle, cette phase gazeuse comprenant un composé réactif précurseur de carbure de silicium ayant la formule suivante : 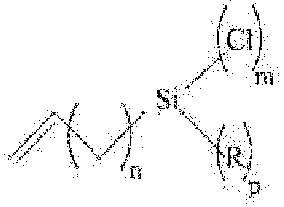 dans laquelle :
   - n est un entier égal à 0 ou 1,
   - m est un entier compris entre 1 et 3,
   - p est un entier compris entre 0 et 2 avec m + p = 3, et
   - R désigne -H ou -CH₃,
le rapport C/Si entre le nombre d'atomes de carbone et le nombre d'atomes de silicium dans la phase gazeuse introduite étant compris entre 2 et 3.

La mise en œuvre d'un précurseur ayant la formule indiquée plus haut (appelé « précurseur A » dans la suite) permet avantageusement d'obtenir une croissance plus rapide du carbure de silicium formé en comparaison avec la mise en œuvre de MTS. L'utilisation d'un tel précurseur permet en outre d'obtenir un meilleur remplissage de la porosité lors de l'infiltration d'un substrat poreux. Les inventeurs ont, par ailleurs, constaté que du carbure de silicium stoechiométrique est obtenu à l'aide du précurseur A bien que ce dernier présente plusieurs atomes de carbone pour un seul atome de silicium. L'obtention d'un tel dépôt stoechiométrique résulte de la limitation de la teneur en carbone dans la phase gazeuse introduite en imposant une valeur comprise entre 2 et 3 pour le rapport C/Si = [teneur atomique en carbone dans la phase gazeuse introduite]/[teneur atomique en silicium dans la phase gazeuse introduite] .

Dans un exemple de réalisation, R peut désigner -H.

Une telle caractéristique est avantageuse car elle participe à réduire davantage encore la teneur en carbone dans la phase gazeuse utilisée.

Dans un exemple de réalisation, n peut être égal à 0.

Une telle caractéristique est avantageuse car elle participe à réduire davantage encore la teneur en carbone dans la phase gazeuse utilisée.

Dans un exemple de réalisation, le composé réactif peut être choisi parmi : le vinylchlorosilane (CH₂CHSiH₂Cl), le vinyldichlorosilane (CH₂CHSiHCl₂), le vinyltrichlorosilane (CH₂CHSiCl₃), le vinylméthylmonochlorosilane (CH₂CHSiCH₃ClH) et l'allyltrichlorosilane (CH₂CHCH₂SiCl₃).

Dans un exemple de réalisation, le composé réactif peut être le vinyltrichlorosilane ou l'allyltrichlorosilane.

Dans un exemple de réalisation, la phase gazeuse peut comporter un unique composé réactif précurseur de carbure de silicium. Dans un exemple de réalisation, la phase gazeuse peut être dépourvue d'un composé réactif additionnel, différent du précurseur A, et comportant du carbone.

Dans un exemple de réalisation, le rapport C/Si peut être égal à 2 ou égal à 3. Le rapport C/Si peut encore être strictement supérieur à 2 et inférieur ou égal à 3. Une telle variante est possible par exemple lorsque la phase gazeuse comprend à la fois un précurseur A à 2 atomes de carbone et un composé réactif additionnel carboné tel que l'acétylène. Dans ce dernier cas, la quantité du composé réactif additionnel carboné dans la phase gazeuse est, bien entendu, limitée de sorte à maintenir le rapport C/Si à une valeur inférieure ou égale à 3.

La présente invention vise également un procédé de fabrication d'une pièce en matériau composite à matrice au moins partiellement en carbure de silicium, le procédé comprenant au moins l'étape suivante :
- densification d'une préforme fibreuse de la pièce à obtenir par une phase de matrice de carbure de silicium stoechiométrique par mise en œuvre d'un procédé tel que décrit plus haut.

La préforme fibreuse peut être formée de fils en matériau céramique ou en carbone.

Dans un exemple de réalisation, la préforme fibreuse peut être formée en une seule pièce par tissage tridimensionnel ou à partir d'une pluralité de strates fibreuses bidimensionnelles.

La pièce ainsi fabriquée peut être une pièce pour application aéronautique ou aérospatiale.

La pièce ainsi fabriquée peut être une pièce de partie chaude d'une turbine à gaz d'un moteur aéronautique ou aérospatial ou d'une turbine industrielle. La pièce peut être une pièce de turbomachine. La pièce peut constituer une partie au moins d'un distributeur, une partie au moins d'une tuyère ou d'un revêtement de protection thermique, une paroi d'une chambre de combustion, un secteur d'anneau de turbine ou une aube de turbomachine.

### Brève description des dessins

D'autres caractéristiques et avantages de l'invention ressortiront de la description suivante, donnée à titre d'exemple non limitatif, en référence aux dessins annexés, sur lesquels :
- la figure 1 représente un ordinogramme des différentes étapes permettant de former du carbure de silicium stoechiométrique dans la porosité d'un substrat poreux par mise en œuvre d'un exemple de procédé selon l'invention,
- la figure 2 représente un ordinogramme des différentes étapes permettant d'obtenir un revêtement de carbure de silicium stoechiométrique à la surface d'un substrat par mise en œuvre d'une variante de procédé selon l'invention,
- la figure 3 est une photographie d'un dépôt de carbure de silicium stoechiométrique obtenu par mise en œuvre d'un exemple de procédé selon l'invention,
- la figure 4 est un résultat expérimental fournissant l'analyse élémentaire du dépôt de carbure de silicium stoechiométrique obtenu dans l'essai associé à la figure 3,
- la figure 5 est une photographie de rainures d'un substrat remplies par du carbure de silicium stoechiométrique par mise en œuvre d'un exemple de procédé selon l'invention,
- la figure 6 est une photographie de rainures d'un substrat remplies par du carbure de silicium par mise en œuvre d'un procédé hors invention, et
- les figures 7 et 8 sont des photographies illustrant l'infiltration chimique en phase vapeur d'une préforme fibreuse par mise en œuvre d'un exemple de procédé selon l'invention.

### Description détaillée de modes de réalisation

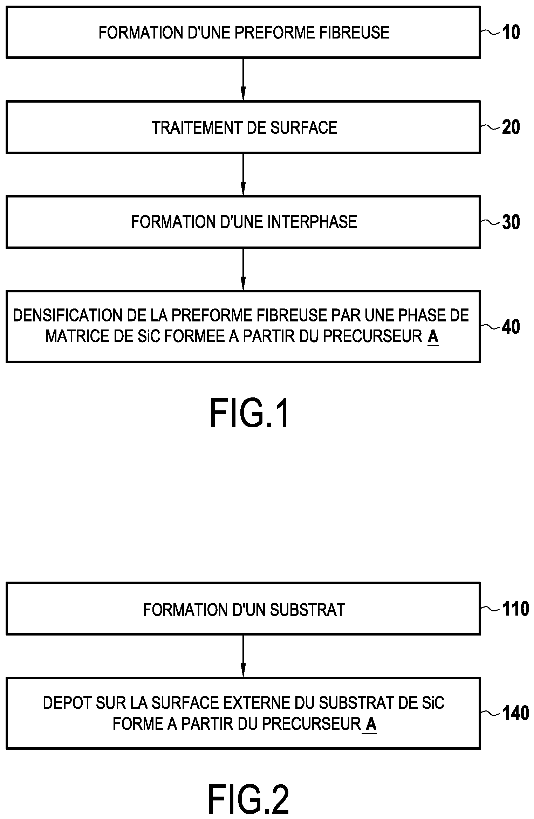

Un exemple de procédé de fabrication d'un substrat poreux et d'infiltration chimique en phase vapeur d'un tel substrat va être décrit en lien avec la figure 1.

Le substrat poreux est tout d'abord formé durant une première étape 10. Dans l'exemple illustré, le substrat poreux est une préforme fibreuse ayant la forme d'une pièce en matériau composite à obtenir. La préforme fibreuse est destinée à constituer le renfort fibreux de la pièce à obtenir. La préforme fibreuse présente une porosité accessible destinée à être en tout ou partie remplie par une matrice au moins partiellement en carbure de silicium.

La préforme fibreuse peut comporter une pluralité de fils céramiques ou en carbone ou encore un mélange de tels fils. On peut par exemple utiliser des fils de carbure de silicium fournis par la société japonaise NGS sous la référence « Nicalon », « Hi-Nicalon » ou encore « Hi-Nicalon Type S ». Les fils de carbone utilisables sont, par exemple, fournis sous la dénomination Torayca T300 3K par la société Toray.

Durant l'étape 10, la préforme fibreuse est obtenue à partir d'au moins une opération textile mettant en œuvre les fils céramiques et/ou carbone. La préforme fibreuse peut, en particulier, être obtenue par tissage multicouches ou tridimensionnel de tels fils.

Par « tissage tridimensionnel » ou « tissage 3D », il faut comprendre un mode de tissage par lequel certains au moins des fils de chaine lient des fils de trame sur plusieurs couches de trame. Une inversion des rôles entre chaine et trame est possible dans le présent texte et doit être considérée comme couverte aussi par les revendications.

La préforme fibreuse peut, par exemple, présenter une armure multi-satin, c'est-à-dire être un tissu obtenu par tissage tridimensionnel avec plusieurs couches de fils de trame dont l'armure de base de chaque couche est équivalente à une armure de type satin classique mais avec certains points de l'armure qui lient les couches de fils de trame entre elles. En variante, la préforme fibreuse peut présenter une armure interlock. Par « armure ou tissu interlock », il faut comprendre une armure de tissage 3D dont chaque couche de fils de chaîne lie plusieurs couches de fils de trame avec tous les fils de la même colonne de chaîne ayant le même mouvement dans le plan de l'armure. Différents modes de tissage multicouches utilisables pour former la préforme fibreuse sont décrits dans le document WO 2006/136755.

Il est aussi possible de partir de textures fibreuses telles que des tissus bidimensionnels ou des nappes unidirectionnelles, et d'obtenir la préforme fibreuse par drapage de telles textures fibreuses sur une forme. Ces textures peuvent éventuellement être liées entre elles par exemple par couture ou implantation de fils pour former la préforme fibreuse.

Une étape 20 de traitement de surface des fils, préalablement à la formation de l'interphase, est de préférence réalisée pour notamment éliminer l'ensimage présent sur les fils.

L'étape 30 consiste à former une interphase de défragilisation par CVI sur les fils formant le renfort fibreux. L'interphase est destinée à être présente entre les fils et la matrice dans la pièce à obtenir. L'interphase peut être monocouche ou multicouches. L'interphase peut comporter au moins une couche de carbone pyrolytique (PyC), de nitrure de bore (BN), de nitrure de bore dopé au silicium (BN(Si), avec du silicium en une proportion massique comprise entre 5% et 40%, le complément étant du nitrure de bore) ou de carbone dopé au bore (BC, avec du bore en une proportion atomique comprise entre 5% et 20%, le complément étant du carbone). L'épaisseur de l'interphase peut par exemple être comprise entre 10 nm et 1000 nm, et par exemple entre 10 nm et 100 nm. Après formation de l'interphase, la préforme fibreuse reste poreuse, la porosité accessible initiale n'étant comblée que pour une partie minoritaire par l'interphase. L'interphase a ici une fonction de défragilisation du matériau composite qui favorise la déviation de fissures éventuelles parvenant à l'interphase après s'être propagées dans la matrice, empêchant ou retardant la rupture des fils par de telles fissures.

Dans l'exemple discuté ici, l'interphase est formée après formation de la préforme fibreuse. On pourrait en variante d'abord former l'interphase sur les fils puis réaliser la préforme fibreuse par mise en œuvre d'une ou plusieurs opérations textiles.

Une fois l'interphase formée, une matrice est formée dans la porosité de la préforme fibreuse afin de densifier cette dernière (étape 40). La matrice enrobe les fils de la préforme fibreuse. Les fils de la préforme sont présents dans la matrice. La matrice comprend une ou plusieurs phase(s) dont au moins une est en carbure de silicium stoechiométrique obtenu à partir du précurseur A. Dans un exemple de réalisation, la matrice peut être intégralement formée de carbure de silicium stoechiométrique obtenu à partir du précurseur A. La formule chimique du précurseur A est rappelée ci-dessous.

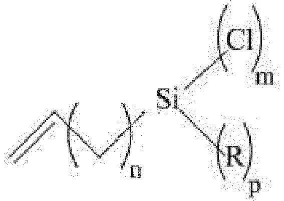

On peut utiliser une installation d'infiltration chimique en phase vapeur du type de celle décrite à la figure 2 du document WO 96/30317 pour réaliser la formation de l'interphase et de la ou des phases de matrice par CVI.

Le carbure de silicium de la matrice est formé à partir d'une phase gazeuse introduite dans l'enceinte réactionnelle dans laquelle la préforme fibreuse est présente. La phase gazeuse comprend le précurseur A et éventuellement un gaz diluant comprenant par exemple un gaz neutre, comme l'argon. La phase gazeuse comprend en outre un composé réducteur, tel que le dihydrogène.

Le rapport Vp/(Vp + Vr) peut être compris entre 3% et 30%, par exemple entre 5 et 15%, avec Vp désignant le volume du précurseur A dans la phase gazeuse introduite et Vr désignant le volume du composé réducteur dans la phase gazeuse introduite. Par ailleurs, le débit d'introduction de la phase gazeuse dans l'enceinte réactionnelle peut être compris entre 100 et 300 cm³/minute (« sccm » ; « standard cubic centimeter per minute ») par exemple entre 150 et 250 cm³/minute.

Durant la formation du carbure de silicium, la température dans l'enceinte réactionnelle peut être comprise entre 700°C et 1400°C, par exemple entre 900°C et 1100°C, et la pression dans l'enceinte réactionnelle peut être comprise entre 10 Pa et 100 kPa, par exemple entre 1 kPa et 30 kPa.

Avantageusement, la phase gazeuse peut être dépourvue d'un composé réactif tiers, différent du précurseur A, et qui comporterait du carbone. Dans la suite, une phase gazeuse où le précurseur A est l'unique précurseur présent sera dénommée « phase gazeuse mono-précurseur ». En particulier, la phase gazeuse peut être dépourvue des composés réactifs suivants : acétylène, éthylène, propylène ou butène.

Comme mentionné plus haut, la phase gazeuse présente un rapport C/Si compris entre 2 et 3 lors de son introduction dans l'enceinte réactionnelle.

Ainsi, lorsque n = 0 dans la formule du précurseur A, on peut avoir :
- p = 0 et m = 3, on a dans ce cas dans la molécule du précurseur 2 atomes de carbone pour un atome de silicium et donc un rapport C/Si de 2 pour une phase gazeuse mono-précurseur,
- p = 1 et m = 2 avec R = -H ou -CH₃. Pour une phase gazeuse mono-précurseur, on aura un rapport C/Si de 2 si R = -H et un rapport C/Si de 3 si R = -CH₃,
- p = 2 et m = 1 avec R = -H ou -CH₃ et la molécule comprenant au plus un radical R = -CH₃ afin de conserver un rapport C/Si inférieur ou égal à 3.

Dans le cas où n = 1 dans la formule du précurseur A, on aura R = -H (pas de radical -CH₃ dans la molécule) afin de maintenir un rapport C/Si égal à 3.

La matrice peut en outre avantageusement comporter une phase complémentaire de matrice en matériau céramique située entre les fibres (ou l'interphase) et la phase de matrice SiC stoechiométrique formée à partir de précurseur A. Cette phase complémentaire peut être en SiC ou être formée d'un matériau différent du SiC. Cette phase complémentaire peut, par exemple, comprendre du Si₃N₄ ou du carbure de bore ou du carbure mixte de bore et de silicium. Bien entendu, lorsqu'une telle phase complémentaire de matrice est présente, la porosité résiduelle de la préforme fibreuse après formation de cette phase complémentaire reste suffisante pour permettre la formation de la phase de matrice SiC stoechiométrique à partir du précurseur A. En variante, la matrice peut être dépourvue d'une telle phase complémentaire.

La pièce peut être une pièce statique ou rotative de turbomachine. Des exemples de pièces de turbomachine selon l'invention ont été mentionnés plus haut.

La figure 2 illustre les différentes étapes d'une variante de procédé selon l'invention. Selon cette variante, on forme sur la surface externe d'un substrat une ou plusieurs couches de carbure de silicium stoechiométrique par dépôt chimique en phase vapeur (« Chemical Vapor Déposition » ; « CVD ») à partir d'une phase gazeuse comprenant le précurseur A. Les mêmes conditions opératoires que dans l'exemple de la figure 1, en termes de pression, température et teneurs, peuvent être mises en œuvre.

Quel que soit l'exemple de réalisation considéré (CVI ou CVD), une pluralité de substrats peut être simultanément traitée par la phase gazeuse dans la même enceinte réactionnelle.

### Exemples

### Exemple 1 (invention)

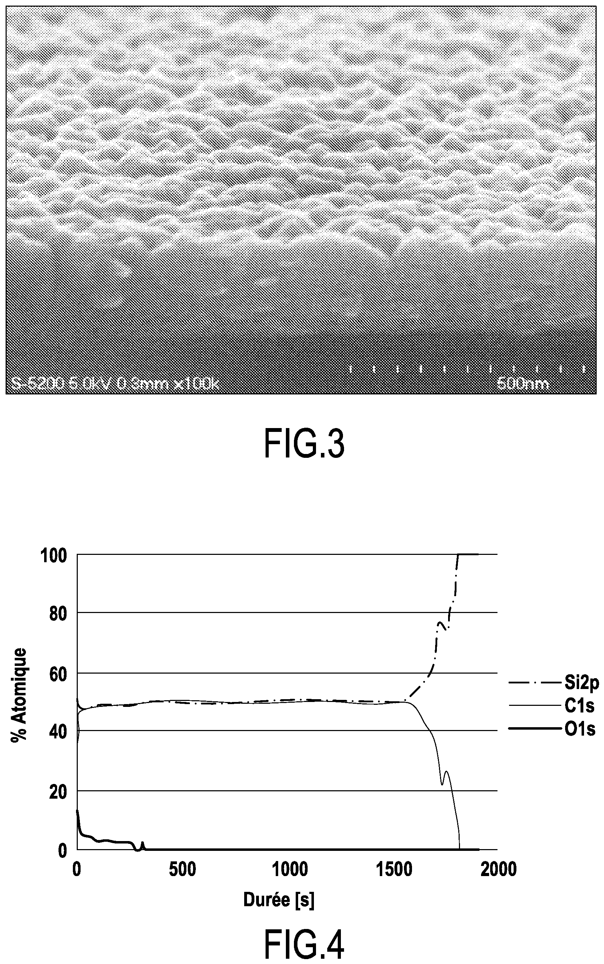

Un substrat (« wafer ») de silicium a été placé dans un réacteur de diamètre 45 mm et de longueur utile 30 cm. Du vinyltrichlorosilane (VTS) et de l'hydrogène dilués dans de l'argon à raison respectivement de 1 sccm, 20 sccm et 980 sccm ont été injectés dans le réacteur à une température de 950°C et à une pression de 23 KPa. Dans cet exemple, le rapport C/Si de la phase gazeuse est égal à 2. On obtient un dépôt de SiC stœchiométrique qui croît à une vitesse de 1,7 µm/heure. La photographie du dépôt obtenu est fournie à la figure 3. La figure 4 est un résultat d'essai montrant l'obtention d'un ratio atomique Si:C de 1 dans le dépôt obtenu, et montrant donc la formation carbure de silicium stoechiométrique.

### Exemple 2 (comparatif)

A titre de comparaison, un substrat (« wafer ») de silicium a été placé dans le même réacteur. Du MTS et de l'hydrogène dilués dans de l'argon à raison respectivement de 5 sccm, 20 sccm et 500 sccm ont été injectés dans le réacteur à une température de 950°C et à une pression de 10 KPa. On obtient un dépôt de carbure de silicium stœchiométrique qui croît à une vitesse de 0,7 µm/heure.

On constate que le dépôt de SiC obtenu avec le VTS a une croissance de dépôt plus de deux fois plus rapide que dans le cas où du MTS est utilisé, et ce bien que cinq fois moins de VTS que de MTS a été introduit dans le four. Il peut donc être constaté que le rendement de dépôt avec le VTS est significativement supérieur au rendement de dépôt avec le MTS.

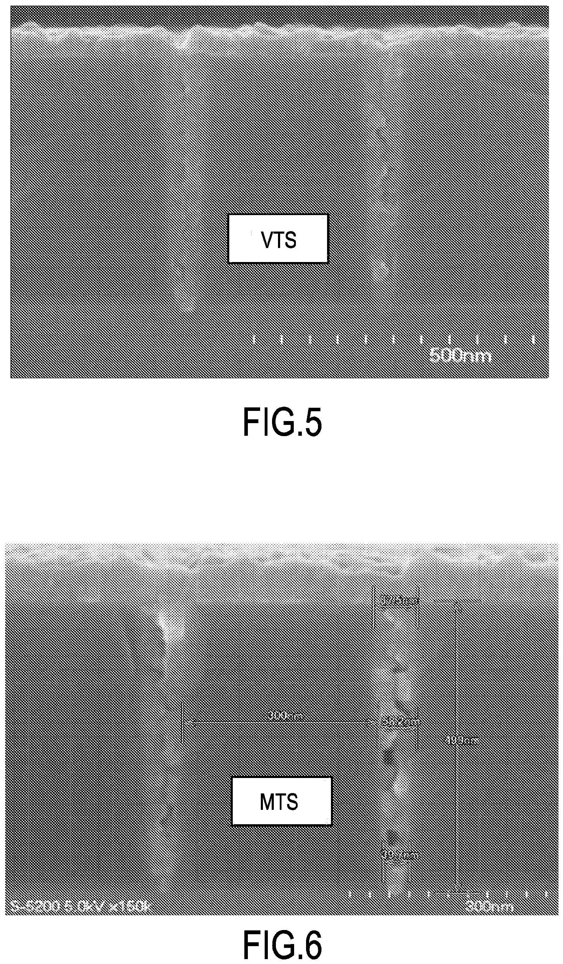

De plus, une comparaison a été effectuée sur l'aptitude à infiltrer de fines rainures 8 fois plus profondes que larges. On constate que le dépôt obtenu à partir de VTS conduit à un meilleur remplissage des rainures que celui obtenu avec le MTS (voir figure 5 pour le VTS et figure 6 pour le MTS). Les capacités d'infiltration obtenues à l'aide du VTS sont, par conséquent, supérieures à celles obtenues avec le MTS.

### Exemple 3 (invention)

Un substrat (« wafer ») de silicium a été placé dans un réacteur de diamètre 45 mm et de longueur utile 30 cm. De l'allyltrichlorosilane (ATS) et de l'hydrogène dilués dans de l'argon à raison respectivement de 1 sccm, 20 sccm et 2000 sccm ont été injectés dans le réacteur à une température de 950°C et à une pression de 10 KPa. Dans cet exemple, le rapport C/Si de la phase gazeuse est égal à 3. On obtient un dépôt de SiC stœchiométrique qui croît à une vitesse de 1,2 µm/heure. Le rendement de dépôt avec l'ATS est donc significativement supérieur à celui obtenu avec le MTS tout en mettant en œuvre une quantité de précurseur bien moindre.

### Exemple 4 (invention)

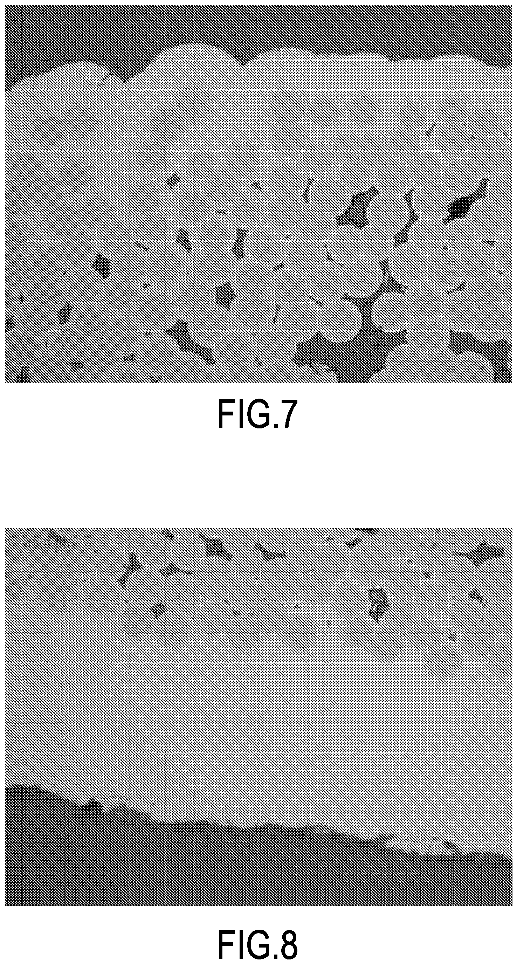

Une préforme fibreuse présentant une texture multicouches de type Guipex^{®} et constituée à partir de fibres Nicalon^{®} a tout d'abord été obtenue. Cette préforme a ensuite été placée dans un conformateur en graphite de sorte à obtenir un taux de fibres de 40%. Ensuite le conformateur a été placé dans un four d'infiltration chimique en phase vapeur afin de réaliser un dépôt d'interphase de pyrocarbone d'épaisseur 150 nm puis un dépôt de matrice en carbure de silicium à partir de MTS de telle sorte que la préforme soit consolidée et puisse conserver sa forme après avoir retiré le conformateur. Ensuite, la préforme a été placée dans un réacteur de diamètre 45 mm et de longueur utile 20 cm. Du VTS et de l'hydrogène à raison respectivement de 13,5 sccm et 280 sccm ont été injectés dans le réacteur à une température de 950°C et à une pression de 8 KPa. Dans cet exemple, le rapport C/Si de la phase gazeuse est égal à 2. On constate, par mesure à la microsonde de Castaing (WDS), l'obtention d'un dépôt de SiC stoechiométrique. La vitesse de croissance du dépôt de SiC stoechiométrique était de l'ordre de 1 µm/heure. La photographie du dépôt obtenu est fournie aux figures 7 (à cœur de préforme dans un fil et autour d'un fil) et 8 (en surface de préforme). On constate que le revêtement est recouvrant aussi bien en surface qu'à cœur de matériau.

L'expression « compris(e) entre ... et ... » doit se comprendre comme incluant les bornes.

## Revendications

1. Procédé d'infiltration ou de dépôt chimique en phase vapeur comprenant au moins l'étape suivante :
- formation de carbure de silicium stoechiométrique dans la porosité d'un substrat poreux ou sur une surface d'un substrat, le substrat étant placé dans une enceinte réactionnelle, le carbure de silicium stoechiométrique étant formé à partir d'une phase gazeuse introduite dans l'enceinte réactionnelle, cette phase gazeuse comprenant un composé réactif précurseur de carbure de silicium ayant la formule suivante : 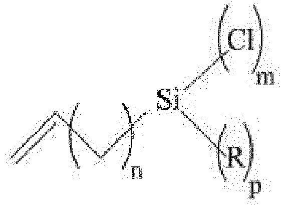 dans laquelle :
- n est un entier égal à 0 ou 1,
- m est un entier compris entre 1 et 3,
- p est un entier compris entre 0 et 2 avec m + p = 3, et
- R désigne -H ou -CH₃,
le rapport C/Si entre le nombre d'atomes de carbone et le nombre d'atomes de silicium dans la phase gazeuse introduite étant compris entre 2 et 3.

2. Procédé selon la revendication 1, dans lequel R désigne -H.

3. Procédé selon l'une quelconque des revendications 1 ou 2, dans lequel n est égal à 0.

4. Procédé selon l'une quelconque des revendications 1 à 3, dans lequel le composé réactif est choisi parmi : le vinylchlorosilane, le vinyldichlorosilane, le vinyltrichlorosilane, le vinylméthylmonochlorosilane et l'allyltrichlorosilane.

5. Procédé selon la revendication 4, dans lequel le composé réactif est le vinyltrichlorosilane ou l'allyltrichlorosilane.

6. Procédé selon l'une quelconque des revendications 1 à 5, dans lequel la phase gazeuse est dépourvue d'un composé réactif additionnel, différent du précurseur A, et comportant du carbone.

7. Procédé selon l'une quelconque des revendications 1 à 6, dans lequel le rapport C/Si est égal à 2 ou à 3.

8. Procédé de fabrication d'une pièce en matériau composite à matrice au moins partiellement en carbure de silicium, le procédé comprenant au moins l'étape suivante :
- densification d'une préforme fibreuse de la pièce à obtenir par une phase de matrice de carbure de silicium stoechiométrique par mise en œuvre d'un procédé selon l'une quelconque des revendications 1 à 7.

9. Procédé selon la revendication 8, la préforme fibreuse étant formée de fils en matériau céramique ou en carbone.

10. Procédé selon l'une quelconque des revendications 8 et 9, la préforme fibreuse étant formée en une seule pièce par tissage tridimensionnel ou à partir d'une pluralité de strates fibreuses bidimensionnelles.

## Patentansprüche

1. Verfahren zur chemischen Gasphaseninfiltration oder - abscheidung, das mindestens den folgenden Schritt umfasst:
- Bildung von stöchiometrischem Siliziumcarbid in der Porosität eines porösen Substrats oder auf einer Oberfläche eines Substrats, wobei das Substrat in einer Reaktionskammer platziert ist, wobei das stöchiometrische Siliziumcarbid ausgehend von einer Gasphase gebildet wird, die in die Reaktionskammer eingeführt wird, wobei diese Gasphase eine reaktionsfähige Vorläuferverbindung von Siliziumcarbid mit der folgenden Formel umfasst: 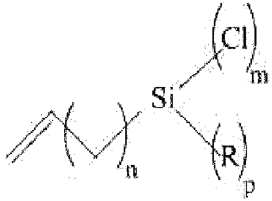 wobei:
- n eine ganze Zahl gleich 0 oder 1 ist,
- m eine ganze Zahl zwischen 1 und 3 ist,
- p eine ganze Zahl zwischen 0 und 2 ist, wobei m + p = 3, und
- R -H oder -CH₃ bezeichnet,
wobei das Verhältnis von C/Si zwischen der Anzahl der Kohlenstoffatome und der Anzahl der Siliziumatome in der eingeführten Gasphase zwischen 2 und 3 beträgt.

2. Verfahren nach Anspruch 1, wobei R -H bezeichnet.

3. Verfahren nach einem der Ansprüche 1 oder 2, wobei n gleich 0 ist.

4. Verfahren nach einem der Ansprüche 1 bis 3, wobei die reaktionsfähige Verbindung ausgewählt ist aus: Vinylchlorsilan, Vinyldichlorsilan, Vinyltrichlorsilan, Vinylmethylmonochlorsilan und Allyltrichlorsilan.

5. Verfahren nach Anspruch 4, wobei die reaktionsfähige Verbindung Vinyltrichlorsilan oder Allyltrichlorsilan ist.

6. Verfahren nach einem der Ansprüche 1 bis 5, wobei die Gasphase keine zusätzliche reaktionsfähige Verbindung umfasst, die sich vom Vorläufer A unterscheidet, und Kohlenstoff umfasst.

7. Verfahren nach einem der Ansprüche 1 bis 6, wobei das Verhältnis von C/Si gleich 2 oder gleich 3 ist.

8. Verfahren zur Herstellung eines Bauteils aus Verbundmaterial mit Matrix zumindest teilweise aus Siliziumcarbid, wobei das Verfahren mindestens den folgenden Schritt umfasst:
- Verdichten einer faserigen Vorform des zu erhaltenen Bauteils durch eine stöchiometrische Siliziumcarbidmatrix durch Durchführen eines Verfahrens nach einem der Ansprüche 1 bis 7.

9. Verfahren nach Anspruch 8, wobei die faserige Vorform aus Fäden aus Keramikmaterial oder aus Kohlenstoff gebildet wird.

10. Verfahren nach einem der Ansprüche 8 und 9, wobei die faserige Vorform einteilig durch dreidimensionales Weben oder ausgehend von einer Vielzahl von zweidimensionalen faserigen Schichten gebildet wird.

## Claims

1. A method of chemical vapor infiltration or deposition comprising at least the following step:
- forming stoechiometric silicon carbide in the pores of a porous substrate or on a surface of a substrate, the substrate being placed in a reaction enclosure, the stoechiometric silicon carbide being formed from a gas phase introduced into the reaction enclosure, the gas phase comprising a reagent compound that is a precursor of silicon carbide and that has the following formula: 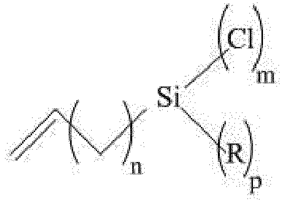
in which:
- n is an integer equal to 0 or 1;
- m is an integer lying in the range 1 to 3;
- p is an integer lying in the range 0 to 2 with m+p=3; and
- R designates -H or -CH₃;
the ratio C/Si between the number of carbon atoms and the number of silicon atoms in the introduced gas phase lying in the range 2 to 3.

2. A method according to claim 1, wherein R designates -H.

3. A method according to claim 1 or claim 2, wherein n is equal to 0.

4. A method according to any one of claims 1 to 3, wherein the reagent compound is selected from: vinylchlorosilane; vinyldichlorosilane; vinyltrichlorosilane; vinylmethylmonochlorosilane; and allytrichlorosilane.

5. A method according to claim 4, wherein the reagent compound is vinyltrichlorosilane or allytrichlorosilane.

6. A method according to any one of claims 1 to 5, wherein the gas phase does not include any additional carbon-containing reagent compound other than the precursor A.

7. A method according to any one of claims 1 to 6, wherein the ratio C/Si is equal to 2 or to 3.

8. A method of fabricating a composite material part having a matrix that is made at least in part out of silicon carbide, the method comprising at least the following steps:
- densifying a fiber preform of the part that is to be obtained with a stoechiometric silicon carbide matrix phase by performing a method according to any one of claims 1 to 7.

9. A method according to claim 8, in which the fiber preform is made from yarns of ceramic material or of carbon material.

10. A method according to claim 8 or claim 9, wherein the fiber preform is formed as a single piece by three-dimensional weaving or else from a plurality of two-dimensional fiber plies.
